(19) Europäisches Patentamt

European Patent Office

Office européen des brevets

(11) **EP 0 658 905 B1**

(12) **EUROPÄISCHE PATENTSCHRIFT**

(45) Veröffentlichungstag und Bekanntmachung des Hinweises auf die Patenterteilung:
**10.04.2002 Patentblatt 2002/15**

(51) Int Cl.⁷: **G11C 29/00**, G11C 16/04

(21) Anmeldenummer: **94119777.4**

(22) Anmeldetag: **14.12.1994**

(54) **Elektronische Speicherschaltung**

Electronic memory circuit

Dispositif électronique de mémoire

(84) Benannte Vertragsstaaten:
**FR GB IT**

(30) Priorität: **15.12.1993 DE 4342821**

(43) Veröffentlichungstag der Anmeldung:
**21.06.1995 Patentblatt 1995/25**

(73) Patentinhaber: **SGS-THOMSON MICROELECTRONICS GMBH**
**85630 Grasbrunn (DE)**

(72) Erfinder:
• **Bonitz, Reiner**
**D-83052 Bruckmühl (DE)**
• **Birkenseher, Peter**
**D-80789 München (DE)**

(74) Vertreter: **Klunker . Schmitt-Nilson . Hirsch**
**Winzererstrasse 106**
**80797 München (DE)**

(56) Entgegenhaltungen:
**EP-A- 0 420 388**

**Beschreibung**

Die Erfindung betrifft eine elektronische Speicherschaltung gemäß Oberbegriff des Anspruchs 1.

Eine derartige Speicherschaltung ist beschrieben in Design + Elektronik, Ausgabe 13, vom 27.6.89, Markt & Technik, Seiten 46, 48 und 49, sowie in Electronic Engineering, September 88, Seiten 44, 45, 48, 50 und 54.

Monolithisch integrierte Halbleiterschaltungen sind insbesondere bei hohem Integrationsgrad komplizierte Gebilde, die hohen Entwicklungsaufwand und umfangreiche Vorarbeit bis zur Serienproduktion erfordern. Deshalb werden für jede integrierte Schaltung möglichst hohe Stückzahlen angestrebt. Mitunter werden von einer bestimmten integrierten Schaltung mehrere Versionen benötigt, die sich oft nur geringfügig unterscheiden. Beispielsweise soll es möglich sein, zwischen einem RC-Oszillator oder einem Quarz-Oszillator als Taktgenerator wählen zu können.

Eine herkömmliche Methode zur Bereitstellung mehrerer ähnlicher Versionen eines bestimmten integrierten Schaltungstyps besteht darin, auf ein und demselben Chip alle Bauelemente für alle Versionen dieses bestimmten integrierten Schaltungstyps vorzusehen und für die unterschiedlichen Versionen verschiedene Leitungsmuster aufzubringen. Dabei werden allerdings unterschiedliche Masken für die Erzeugung des je erforderlichen Leitungsmusters benötigt.

Diesen Aufwand kann man dadurch vermeiden, daß man ein und dieselbe integrierte Schaltung mit allen für ihre verschiedenen Versionen erforderlichen Schaltungsteilen und Leitungsmustern ausstattet und daß man diese integrierte Schaltung mit Schaltern ausrüstet, mit denen eine interne Umschaltung auf die jeweils gewünschte Version mit Hilfe entsprechender Schaltsteuersignale erfolgt. Dies führt auch zu dem Vorteil, daß man eine solche integrierte Schaltung noch während der Entwicklungsphase oder sogar noch während des Einsatzes von der zunächst gewählten Version in eine andere Version umschalten kann.

Hierfür ist eine Speicherschaltung der eingangs angegebenen Art verwendbar. Dabei lassen sich die Schalter der integrierten Schaltung in Abhängigkeit von dem Speicherzustand der Speicherschaltung steuern.

Die EP-A2-0 420 388 zeigt eine Test-Zwischenspeicherschaltung zum Abspeichern von Konfigurationsinformation für ein programmierbares logisches Bauelement. Für den Normalbetrieb wird die Konfigurationsinformation in nicht-flüchtige Speicherelemente eingeschrieben. Beim Testbetrieb erfolgt die Speicherung der Konfigurationsinformation nur in Zwischenspeichern, die den nichtflüchtigen Speicherelementen zugeordnet sind. Dies ermöglicht ein Testen der Schaltung mit der zwischengespeicherten Information, ohne daß bereits in dieser Testphase der nicht-flüchtige Speicher beschrieben werden muß. Das Zwischenspeichern der Konfigurationsinformation kann für den Testbetrieb vergleichsweise schnell erfolgen, so daß ein Testen der Schaltung innerhalb relativ kurzer Zeit möglich ist.

Bekanntlich weisen EPROM-Transistoren zwischen dem Leitungskanal und dem Steuergate ein Floating-Gate auf. Das Floating-Gate des EPROM-Transistors enthält im unprogrammierten Zustand keine Ladungen, während es im programmierten Zustand Ladungen enthält. Betrachtet man einen N-Kanal-EPROM-Transistor, so enthält sein Floating-Gate im unprogrammierten Zustand keine negativen Ladungen. Der EPROM-Transistor wird daher leitend, wenn man eine Spannung von etwa 1,9 V an das Steuer-Gate anlegt. Beim programmierten N-Kanal-EPROM-Transistor befinden sich negative Ladungen auf dem Floating-Gate, was bedeutet, daß ein solcher Transistor im programmierten Zustand erst ab einer Steuer-Gate-Spannung von mehr als 5 V leitet.

Dieses unterschiedliche Verhalten zwischen programmiertem und unprogrammiertem EPROM-Transistor wird für die Informationsspeicherung ausgenutzt. Diese Information kann beispielsweise dazu verwendet werden, in der bereits genannten Weise den Schaltzustand von Hardware-Schaltern zu steuern, die sich auf demselben Halbleiter-Chip wie die Speicherschaltung befinden.

Bei einer Speicherschaltung der eingangs angegebenen Art kann kein Fehler auftreten in Form der Abgabe einer falschen Speicherinformation. Nach Störungen nimmt diese Speicherschaltung selbständig immer wieder den richtigen Schaltungszustand an, in dem sie die programmierte Speicherinformation zuverlässig abgibt. Kommt es zu einem Versorgungsspannungsabfall, sei es aufgrund von Störungen oder durch bewußtes Abschalten, genügt allein das Wiedereinschalten der Versorgungsspannung, um wieder die korrekte Speicherinformation abzugeben. Es wird keinerlei Auslesesignal benötigt.

Eine derartige Speicherschaltung eignet sich nicht nur zur Bereitstellung von Schaltsteuerinformationen für Schalter. Sie läßt sich überall dort vorteilhaft verwenden, wo Information zuverlässig gespeichert und korrekt ausgegeben werden soll, auch über sehr lange Zeit und unbeeinträchtigt von Störungen. Diese Speicherschaltung eignet sich beispielsweise auch hervorragend für nicht-flüchtige Speicher.

Es ist im allgemeinen erforderlich, die Speicherschaltung und die von ihr gesteuerte Schaltung mehrfach zu testen. Es mag auch erforderlich werden, die Funktionen der von der Speicherschaltung gesteuerten Schaltung nachträglich zu ändern, was eine Änderung des Speicherinhaltes der Speicherschaltung und somit deren Umprogrammierung bedarf. Möglicherweise sind Tests und/oder Umprogrammierungen während des Betriebes der gesteuerten Schaltung erforderlich, ohne daß dieser Betrieb unterbrochen oder gestört wird.

Der Erfindung liegt die Aufgabe zugrunde, eine Speicherschaltung der eingangs angegebenen Art so weiter zu bilden, daß derartige Tests und Umprogrammierungen auf einfache und bequeme Art und Weise möglich sind.

Eine Lösung dieser Aufgabe ist in Anspruch 1 angegeben. Vorteilhafte Weiterbildungen ergeben sich aus den Unteransprüchen.

Bei der erfindungsgemäßen Speicherschaltung ist es durch Zuführen lediglich entsprechend ausgewählter Logiksignale möglich, in sehr flexibler und vielfältiger Weise Tests durchzuführen, von dem jeweiligen Programmierungszustand abweichende Speicherzustände zu simmulieren, ohne eine Umprogrammierung vornehmen zu müssen, andere Funktionen der von der Speicherschaltung gesteuerten Schaltungsanordnung zu überprüfen, als die von dem Speicherinhalt der Speicherschaltung vorgegebenen Schaltungszustände, und sogar bei Verwendung nur einmal programmierbarer Speicherelemente ein mehrmaliges Testen mit anderem als dem einmal programmierten Speicherinhalt durchzuführen.

Ist die Speicherschaltung mit Speicherelementen aufgebaut, die wiederholt programmiert werden können, kann man dies mit Hilfe der Programmiereinrichtung der erfindungsgemäßen Speicherschaltung jederzeit tun.

Als Programmiertransistoren verwendet man vorzugsweise spannungsfeste Transistoren, d.h., Transistoren, die mindestens die bei einem Programmiervorgang auftretenden Spannungswerte ohne Schaden vertragen.

Mit den Sperr-Transistoren werden außer den beiden EPROM-Transistoren sämtliche Schaltungskomponenten der Speichereinrichtung während eines Programmiervorgangs abgeschirmt. Zu diesem Zweck werden die Sperr-Transistoren während eines Programmiervorgangs in den Sperrzustand geschaltet, während sie ansonsten leiten. Auch für die Sperr-Transistoren werden vorzugsweise spannungsfeste Transistoren verwendet.

Um von dem Speicherinhalt der Speicherschaltung gesteuerte Schaltungsteile hinsichtlich ihrer Reaktion auf unterschiedliche Speicherinhalte testen zu können, ohne die EPROM-Transistoren zu diesem Zweck umprogrammieren zu müssen, sind den EPROM-Transistoren je ein Simulationstransistor parallelgeschaltet, mit denen das Leitendschalten eines an sich gesperrten EPROM-Transistors simuliert werden kann.

Vorzugsweise wird an den Ausgang der Speicherschaltung eine Halteschaltung angeschlossen, mittels welcher der jeweilige Speicherwert der Speicherschaltung festgehalten werden kann. Dies hat den Vorteil, daß ein mit dem Ausgangssignal der Speicherschaltung gesteuerter Schalter durch Programmieroder Testvorgänge nicht gestört wird. Solches Programmieren oder Testen kann man je nach Wunsch durchführen, mit oder ohne Speicherung mittels der Halteschaltung.

Die Referenzspannungsquelle der erfindungsgemäßen Speicherschaltung erlaubt trotz eines relativ einfachen Schaltungsaufbaus einen sehr vielfältigen und flexiblen Betrieb der Speicherschaltung.

Der Begriff "EPROM" ist bekanntermaßen eine Abkürzung für "Erasable Programmable ROM", also für ein programmierbares ROM, dessen Programmierung wieder löschbar ist. Hierfür sind zwei verschiedene Typen bekannt. Bei einem ersten Typ, den man üblicherweise als "EPROM" bezeichnet, wird die Programmierung durch Bestrahlung mit UV-Licht gelöscht. Bei einem anderen Typ wird die Programmierung auf elektrischem Wege gelöscht. Die übliche Bezeichnung für diesen Typ ist "$E^2PROM$" (Electrically Erasable Programmable ROM). Im vorliegenden Fall soll der Begriff "EPROM" beide Typen von löschbar programmierbaren ROM umfassen. Beide Typen sind in der gleichen Speicherschaltung einsetzbar. Während bei dem mittels UV-Licht löschbaren EPROM die Programmiereinrichtung nur zum Programmieren und möglicherweise zum Auslesen des Speicherinhalts der EPROMs verwendet wird, wird bei dem elektrisch löschbaren $E^2PROM$ die Programmiereinrichtung zusätzlich zum Löschen verwendet. Für das Programmieren und Löschen und gegebenenfalls das Auslesen werden dann lediglich entsprechend unterschiedliche Spannungen von der Programmiereinrichtung an die Anschlüsse der $E^2PROM$-Transistoren gegeben.

Es ist auch denkbar, einen Teil der Transistoren der gesamten Speicherschaltung durch bipolare Transistoren zu realisieren. Dies gilt für alle Transistoren mit Ausnahme der EPROM-Transistoren selbst.

Die Erfindung und vorteilhafte Weiterbildungen der Erfindung werden nun anhand von Ausführungsformen näher erläutert. In den Zeichnungen zeigen:

**Fig. 1**　eine erste Ausführungsform der erfindungsgemäßen Speicherschaltung;.

**Fig. 2**　eine zweite Ausführungsform einer erfindungsgemäßen Speicherschaltung, die zusätzlich zu der in Fig. 1 gezeigten Ausführungsform eine Halteeinrichtung aufweist;

**Fig. 3**　eine Ausführungsform einer Referenzspannungsquelle der erfindungsgemäßen Speicherschaltung; und

**Fig. 4**　eine Schaltungsanordnung, bei welcher eine erfindungsgemäße Speicherschaltung zu Steuerung einer Schaltungsanordnung verwendet wird.

Bei der folgenden Beschreibung von Ausführungsbeispielen der Erfindung wird davon ausgegangen, daß es sich bei den EPROM-Transistoren um mittels UV-Licht löschbare EPROMs handelt.

In den Figuren sind P-Kanal-Transistoren mit einem kleinen Kreis an dem Steuergate gekennzeichnet. Bei Transistoren ohne einen solchen Kreis handelt es sich um N-Kanal-Transistoren.

Transistoren, die in den Figuren mit zwei Sternchen (\*\*) gekennzeichnet sind, sind als spannungsfeste Transistoren ausgebildet, damit sie die gegenüber der Versorgungsspannung relativ hohen Programmierspannungen ohne Gefährdung und Schädigung überstehen. Dies betrifft durchweg N-Kanal-Transistoren, da P-Kanal-Transistoren von Haus aus mit einer höheren Spannungsfestigkeit hergestellt werden.

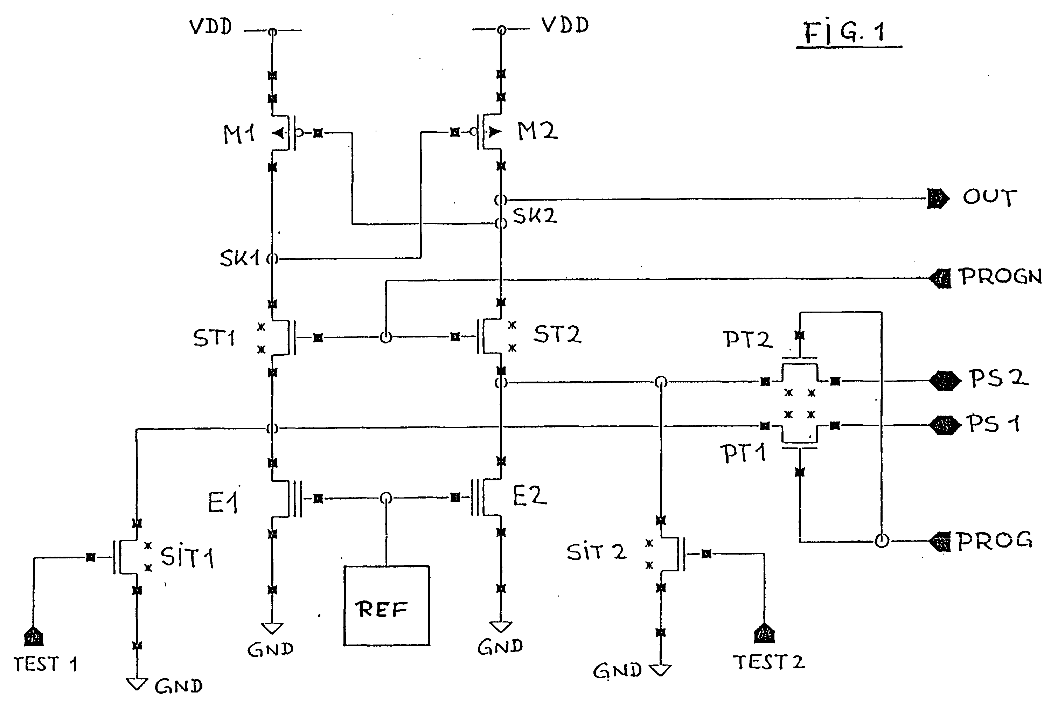

**Fig. 1** zeigt eine erste Ausführungsform einer erfindungsgemäßen Speicherschaltung. Zwischen eine Versorgungsspannungsleitung VDD, die beispielsweise eine Versorgungsspannung von 5 V führt, und eine mit Masse verbundene Erdleitung GND sind eine erste Reihenschaltung mit einem ersten EPROM-Transistor E1, einem ersten Sperrtransistor ST1 und einem ersten MOS-Transistor M1 und eine zweite Reihenschaltung mit einem zweiten EPROM-Transistor E2, einem zweiten Sperrtransistor ST2 und einem zweiten MOS-Transistor M2 parallelgeschaltet. Die Steuer-Gates der beiden EPROM-Transistoren E1 und E2 sind gemeinsam an eine Referenzspannungsquelle REF angeschlossen. Ein erster Schaltungsknoten SK1 zwischen ST1 und M1 ist an das Gate von M2 angeschlossen. Ein zweiter Schaltungsknoten SK2 zwischen ST2 und M2 ist an das Gate von M1 angeschlossen. Der zweite Schaltungsknoten SK2 bildet den Ausgang OUT der Speicherschaltung.

Ein unprogrammierter EPROM-Transistor enthält keine negativen Ladungen auf seinem Floating-Gate und wird deshalb leitend, wenn man an sein Steuer-Gate eine Spannung von etwa 1,9 V anlegt. Dieser Spannungswert kann für EPROM-Transistoren, die unter Verwendung verschiedener Prozesse hergestellt werden, etwas verschieden sein. Beim programmierten EPROM-Transistor befinden sich negative Ladungen auf dem Floating-Gate. Dies bedeutet, daß ein solcher Transistor erst ab einer Gate-Spannung von etwa 5 V leitet. Hierbei ist an N-Kanal-EPROM-Transistoren gedacht. Es sind aber auch P-Kanal-EPROM-Transistoren einsetzbar, bei entsprechender Anpassung der Speicherschaltung.

Die Referenzspannungsquelle REF liefert im Normalbetrieb an die Steuer-Gates der beiden EPROM-Transistoren E1 und E2 eine Referenzspannung von etwa 3 V. Der gelöschte oder unprogrammierte EPROM-Transistor leitet daher, während der programmierte EPROM-Transistor sperrt. Geht man beispielsweise davon aus, daß E1 unprogrammiert und E2 programmiert ist, leitet bei dieser Referenzspannung E1, während E2 sperrt. Da E1 leitet, befindet sich der erste Schaltungsknoten SK1 auf niedrigem Potential, so daß M2 leitet. Aus diesem Grund, und weil E2 gesperrt ist, befindet sich der zweite Schaltungsknoten SK2 auf hohem Potential. Am Ausgang OUT der Speicherschaltung ist daher ein Logikwert H vorhanden, dem man den Binärwert "1" zuordnen kann. Da diese hohe Ausgangsspannung am Gate von M1 anliegt, ist dieser gesperrt.

Der Ausgangszustand von OUT ist stabil und es fließt durch die Speicherschaltung kein Querstrom, da in jeder Reihenschaltung ein Transistor sperrt.

Wie man sieht, wird kein Auslesesignal benötigt. Es genügt allein das Einschalten der Versorgungsspannung, von der auch die Referenzspannung abgeleitet wird. Auch durch ein vorübergehendes Ausfallen der Versorgungsspannung, sei es durch Ausschalten oder aufgrund von Störungen, steht die korrekte Speicherinformation wieder am Ausgang OUT zur Verfügung, sobald die Versorgungsspannung wieder vorhanden ist.

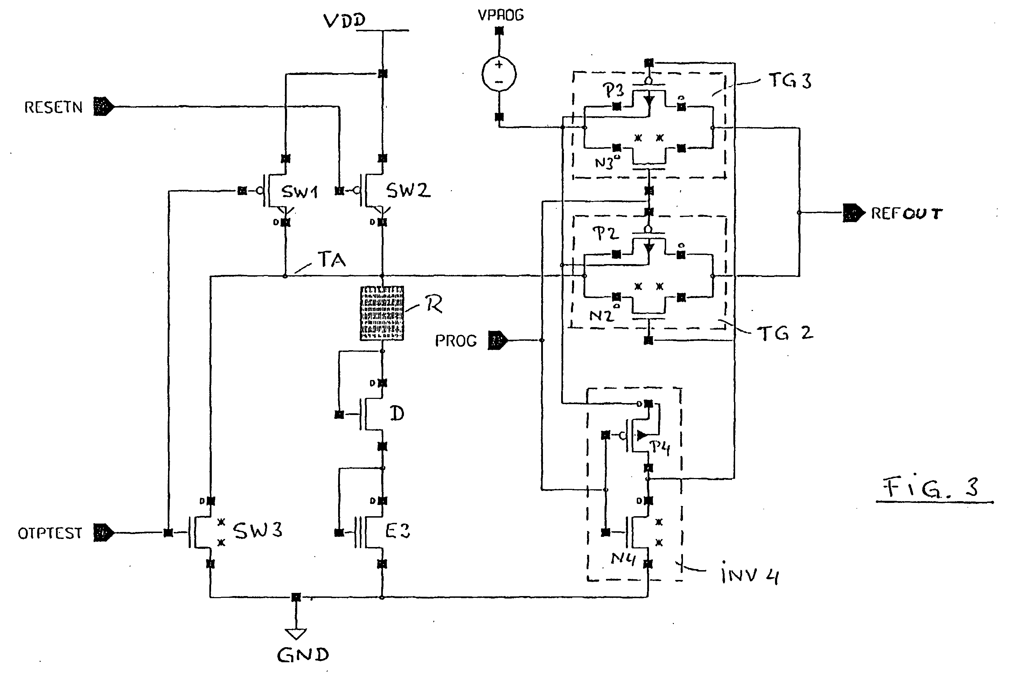

Die Programmiereinrichtung der erfindungsgemäßen Speicherschaltung umfaßt einen ersten Programmier-Transistor PT1 und einen zweiten Programmier-Transistor PT2, über welche die nicht mit GND verbundene Seite von E1 bzw. E2 mit einer ersten Programmiersignalquelle PS1 bzw. einer zweiten Programmiersignalquelle PS2 verbunden sind. Die Gates von PT1 und PT2 sind gemeinsam an eine Programmiersteuersignalquelle PROG angeschlossen. Während eines Programmiervorgangs erhalten die Steuer-Gates der EPROM-Transistoren E1 und E2 eine Referenzspannung von etwa 12,5 V. Wie dies die Referenzspannungsquelle bewirkt, wird weiter unten anhand von Fig. 3 näher erläutert werden.

Während eines Programmiervorgangs werden die Programmier-Transistoren PT1 und PT2 durch ein Programmiersteuersignal (PROG) leitend geschaltet, bei gleichzeitiger Abgabe einer Referenzspannung von etwa 12,5 V an die Steuer-Gates von E1 und E2. Derjenige der beiden EPROM-Transistoren E1 und E2, der programmiert werden soll, erhält über den zugehörigen Programmier-Transistor PT1 bzw. PT2 von der zugehörigen Programmiersignalquelle PS1 bzw. PS2 eine Programmierspannung von etwa 7 V. Von dem daraus resultierenden Strom durch den zu programmierenden EPROM-Transistor werden wegen der hohen Referenzspannung von etwa 12,5 V aufgrund eines Tunneleffektes Ladungsträger in das Floating-Gate gesaugt, die dort nach dem Programmiervorgang verbleiben. Anstelle zweier Programmiersignalquellen PS1 und PS2 kann man auch eine einzige gemeinsame Programmiersignalquelle verwenden und die Auswahl des jeweils zu programmierenden EPROM-Transistors E1, E2 allein durch entsprechend selektives Ansteuern von PT1 und PT2 erreichen.

Die Sperr-Transistoren ST1 und ST2 sind als spannungsfeste Transistoren ausgebildet und sollen die oberhalb dieser Sperr-Transistoren ST1 und ST2 befindlichen Schaltungsteile von dem Programmiervorgang und den damit verbundenen hohen Spannungen abschirmen. Zu diesem Zweck sind die Gates von ST1 und ST2 gemeinsam mit einer Steuersignalquelle PROGN verbunden, die diesen Gates eine invertierte Version des Programmiersteuersignals der Programmiersteuersignalquelle PROG liefert. Dadurch werden die Sperr-Transistoren ST1 und ST2 während eines Programmiervorgangs gesperrt, während sie außerhalb solcher Programmiervorgänge leitend geschaltet sind.

Die erfindungsgemäße Speicherschaltung weist zusätzlich Simulations-Transistoren SIT1 und SIT2 auf, die dem ersten EPROM-Transistor E1 bzw. dem zweiten EPROM-Transistor E2 parallelgeschaltet sind. Die Gates von SIT1 und SIT2 sind mit einer Testsignalquelle TEST1 bzw. TEST2 verbunden. Beide Transistoren sind als spannungsfeste Transistoren ausgebildet.

Die Simulations-Transistoren SIT1 und SIT2 sind vorgesehen, um die von dem Ausgangssignal der Speicherschaltung angesteuerten Schaltungsteile hinsichtlich ihres Verhaltens bei unterschiedlichem Speicherinhalt der Speicherschaltung testen zu können, ohne hierfür die EPROM-Transistoren E1 und E2 umprogrammieren zu müssen oder wenn anstelle der EPROM-Transistoren nur einmal programmierbare PROM-Elemente vorgesehen sind. Die Simulation geschieht dadurch, daß ein programmierter EPROM-Transistor oder ein programmiertes PROM-Element, der bzw. das bei dem normalerweise anliegenden niedrigeren Referenzspannungswert von etwa 3 V sperrt, durch einen leitenden Simulations-Transistor überbrückt wird.

Um beide Signalzustände des Ausgangs OUT der Speicherschaltung zu realisieren, wäre es normalerweise erforderlich, für eine erste Testphase die Konstellation E1 programmiert/E2 unprogrammiert und in einer anderen Testphase die Konstellation E1 unprogrammiert/E2 programmiert herzustellen. Dies würde ein zeitaufwendiges Zwischenlöschen mittels UV-Bestrahlung der EPROM-Transistoren E1, E2 notwendig machen. Dieses Erfordernis kann durch die Simulations-Transistoren SIT1, SIT2 vermieden werden. Nachdem zum Beispiel die erste Konstellation, E1 programmiert / E2 unprogrammiert, realisiert und getestet wurde, wird anschließend auch E2 programmiert. Die zweite Möglichkeit, E1 unprogammiert / E2 programmiert, kann dann simuliert werden, indem E1 durch SIT 1 überbrückt wird. D.h., daß dann beide EPROM-Transistoren E1 und E2 programmiert sind und mit den Simulationstransistoren SIT1 und SIT2 sämtliche Programmierungskonstellationen von E1 und E2 simuliert werden können. Anstelle oder zusätzlich zu den E1 und E2 parallel geschalteten Simulationstransistoren SIT1 und SIT2 kann man Simulationstransistoren verwenden, die zu E1 und E2 in Reihe geschaltet sind und je nach zu simulierender Konstellation sperrend oder leitend geschaltet werden. Hierfür könnte man auch die bereits vorhandenen Sperrtransistoren ST1 und ST2 verwenden, die dann allerdings getrennt mit zwei verschiedenen Testsignalquellen ansteuerbar sein müßten. Durch diese Simulation kann man ohne Umprogrammierung einen Schalter, der vom Signal am Ausgang OUT der Speicherschaltung gesteuert wird, abwechselnd in beide Schaltzustände bringen, um zu beobachten, wie die dem Schalter nachfolgende Schaltungsanordnung reagiert. Vorzugsweise sollte aus Sicherheitsaspekten ein Schalten der Simulations-Transistoren SIT1, SIT2 in einen simulierenden Zustand nur während eines Testbetriebs möglich sein.

Die Speicherschaltung kann auch mit nur einmal programmierbaren Speicherzellen (PROM) aufgebaut werden. Die Testprozedur für diesen Fall ist nachfolgend im Zuammenhang mit den verschiedenen Betriebsmöglichkeiten der Referenzspannungsquelle REF genauer beschrieben.

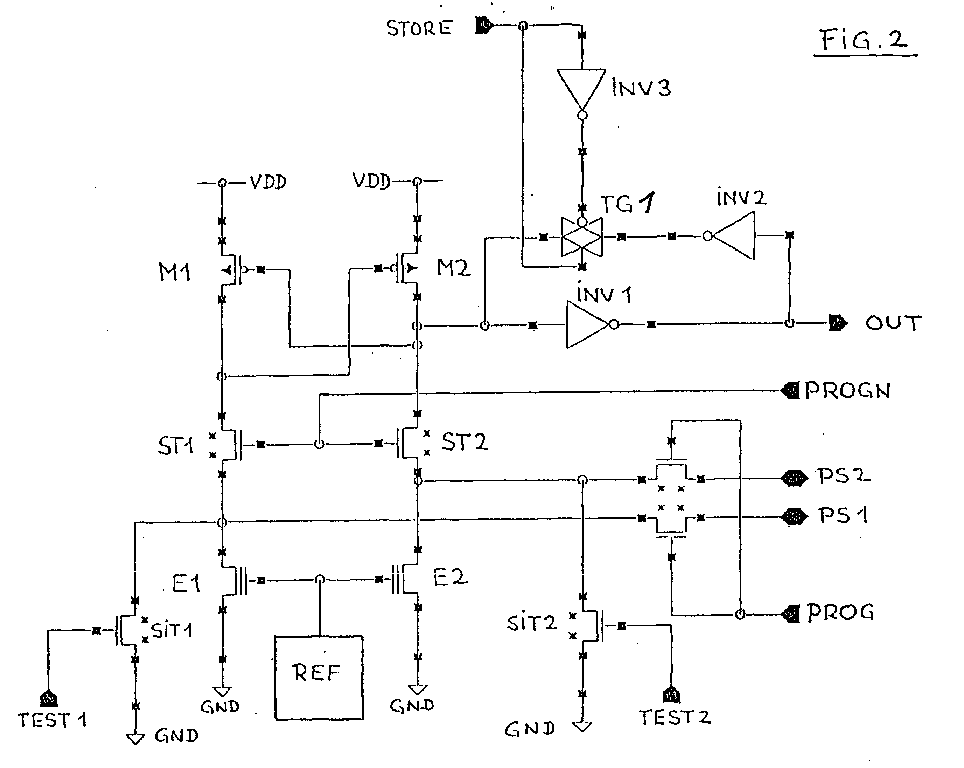

Fig. 2 zeigt eine Ausführungsform der erfindungsgemäßen Speicherschaltung, die zusätzlich zu der in Fig. 1 dargestellten Ausführungsform eine Halteschaltung oder ein LATCH aufweist. Dieses besitzt nach bekannter Art zwischen SK2 und OUT einen ersten Inverter INV1, der von einer Reihenschaltung aus einem zweiten Inverter INV2 und einem sogenannten Transmissions-Gate TG1 überbrückt ist. TG1 ist durch die Parallelschaltung eines P-Kanal-Transistors und eines N-Kanal-Transistors gebildet. Diese Parallelschaltung verwendet man, weil eine "1" nur von einem P-Kanal-Transistor und eine "0" nur von einem N-Kanal-Transistor sauber durchgeschaltet wird.

Den Gates der beiden Transistoren des Transmissions-Gates TG1 wird direkt bzw. über einen dritten Inverter INV3 ein Speichersteuersignal STORE zugeführt. Dieses aktiviert die Halteschaltung nur dann, wenn für die Durchführung eines Programmiervorgangs die Sperr-Transistoren ST1 und ST2 in den Sperrzustand gebracht werden. Vor Beginn eines solchen Programmiervorgangs und damit vor dem Sperren von ST1 und ST2 wird die dann gerade am zweiten Schaltungsknoten SK2 vorhandene aktuelle Speicherinformation gespeichert. Der an den Ausgang OUT angeschlossene Schalter kann nicht springen und damit beim Programmiervorgang Störungen verursachen.

Die in Fig. 2 dargestellte Ausführungsform einer erfindungsgemäßen Speicherschaltung vereint in sich:

- Speicherfähigkeit
- Programmierbarkeit und Lesbarkeit der EPROM-Transistoren
- Testbarkeit
- Störunempfindlichkeit im Normalbetrieb, aber auch während des Testens und Programmierens.

Die Lesbarkeit ist dadurch gegeben, daß man über die mit den Programmiersignalquellen PS1 und PS2 verbundenen Leitungen die Programmierzustände der EPROM-Transistoren E1 und E2 auslesen kann.

In den Fig. 1 und 2 ist eine Referenzspannungspannungsquelle der Referenzspannungsschaltung REF als Schaltungsblock dargestellt, der den Steuergates der beiden EPROM-Transistoren E1 und E2 gemeinsam eine Referenspannung VREF zuführt. Die Referenzspannungsquelle REF wird nun anhand von **Fig. 3** näher erläutert.

Die in **Fig. 3** gezeigte Referenzspannungsquelle weist einen Spannungsteiler mit einer Reihenschaltung mit einem ersten Schalttransistor SW1, einem diffundierten niederohmigen Widerstand R, einem als Diode geschalteten Transistor D und einem ebenfalls als Diode geschalteten dritten EPROM-Transistor E3 auf. Diese Reihenschaltung ist zwischen die. beiden Pole VDD und GND einer Versorgungsspannungsquelle geschaltet. Zwischen SW1 und R befindet sich ein Teilspannungsabgriffspunkt TA des Spannungsteilers. Der erste Schalttransistor SW1 ist derart hergestellt, daß er auch im leitenden Zustand hochohmig ist. Vorzugsweise weist er im leitenden Zustand einen Widerstand im Bereich von etwa 10 MΩ bis etwa 20 MΩ auf. Hierdurch wird erreicht, daß durch den Spannungsteiler auch bei leitend geschaltetem SW1 immer nur ein sehr kleiner Strom von maximal einigen 100 nA fließt. Dadurch wird die Versorgungsspannungsquelle geschont, was insbesondere dann wichtig ist, wenn diese durch eine Batterie gebildet wird.

Dem ersten Schalttransistor SW1 ist ein zweiter Schalttransistor SW2 parallel geschaltet, der im leitenden Zustand niederohmig ist.

Dem zwischen TA und GND befindlichen Teil des Spannungsteilers ist ein dritter Schalttransistor SW3 parallel geschaltet.

Die Gateelektroden von SW1 und SW3 sind gemeinsam mit einer Logiksignalquelle OTPTEST verbunden. Der Gateanschluß von SW2 ist mit einer Logiksignalquelle RESETN verbunden.

Zwischen den Teilspannungsabgriffspunkt TA und einem Ausgangsanschluß REFOUT der Referenzspannungsquelle ist ein zweites Transmissionsgate TG2 geschaltet, das im leitenden Zustand die am Teilspannungsabgriffspunkt TA anliegende Spannung zum Ausgang REFOUT durchschaltet.

Zwischen einer Programmierspannungsquelle VPROG und den Ausgang ist ein drittes Transmissionsgate TG3 geschaltet, das im leitenden Zustand die Programmierspannung VPROG zum Ausgang REFOUT der Referenzspannungsschaltung REF durchschaltet. Die Transmissionsgates TG2 und TG3 weisen aus den Gründen, wie sie bereits im Zusammenhang mit TG1 in **Fig. 2** erläutert worden sind, in Parallelschaltung sowohl einen P-Kanal-Transistor als auch einen N-Kanal-Transistor auf, damit sie sowohl den Spannungswert eines Logiksignals "0" als auch den Spannungswert eines Logiksignals "1" problemlos durchschalten.

TG2 enthält die Parallelschaltung eines N-Kanal-Transistors N2 und eines P-Kanal-Transistors P2. TG3 enthält die Parallelschaltung eines N-Kanal-Transistors N3 und eines P-Kanal-Transistors P3.

Die Steuergates von P2 und N3 sind direkt mit einer Logiksignalquelle PROG verbunden, während die Steuergates von N2 und P3 mit der Logiksignalquelle PROG über einen vierten Inverter INV4 verbunden sind. INV4 enthält in Reihenschaltung einen P-Kanal-Transistor P4 und einen N-Kanal-Transistor N4.

Bei der dargestellten Ausführungsform liefert die Versorgungsspannungsquelle eine Versorgungsspannung VDD=5V. Die Programmierspannung VPROG beträgt während eines Programmiervorgangs 12,5 V, ansonsten wie die Versorgungsspannung 5 V. Der Spannungswert des Logiksignals PROG beträgt dann, wenn dieses den Logikwert "1" oder "H" aufweist, ebenfalls 12,5 V. Für die Logiksignale RESETN und OTPTEST reichen die üblichen Logiksignal-Werte aus.

Die Referenzspannungsquelle REF soll zum einen das Auslesen der elektronischen Speicherzelle in **Fig. 1 oder 2** während des Betriebs bewirken. Sie soll darüberhinaus aber auch das Programmieren der Speicherzelle ermöglichen und die Testbarkeit unterstützen.

Im folgenden wird die Funktionsweise der Referenzspannungsquelle REF für verschiedene Betriebszustände erläutert.

1. Normalbetrieb:

Im Normalbetrieb stehen die Eingangssignale der Referenzspannungsschaltung REF auf folgenden logischen Pegeln:

$$OTPTEST = 0$$

$$RESETN = 1$$

$$PROG = 0$$

Außerdem ist

$$VPROG = VDD.$$

Infolge dieser Eingangswerte sind die Transistoren SW2, SW3, N3, P3 und N4 sperrend geschaltet. Die Transistoren SW1, N2, P2 und P4 sind leitend geschaltet.

Da die Transistoren D und E3 je dadurch als Diode geschaltet sind, daß ihre Steuergates mit ihren Drain-Anschlüssen verbunden sind, befinden sich D und E3 in der sogenannten schwachen Inversion und an jedem dieser beiden Transistoren beträgt der Spannungsabfall ungefähr dessen Einsetzspannung $V_{TH}$, bei welcher der jeweilige Transistor leitend wird. Im Fall des Transistors D beträgt die Einsetzspannung etwa +0,9 V. Der dritte EPROM-Transistor E3 befindet sich im gelöschten (nicht programmierten) Zustand und weist daher eine Einsetzspannung von etwa +1,9 V auf. Solange die Versorgungsspannung VDD ausreichend groß ist, bilden D und E3 je ein Bauelement mit konstant bleibendem Spannungsabfall, wobei die Summe dieser Spannungsabfälle etwa 2,8 V beträgt. Da der diffundierte Widerstand R niederohmig ist, liegt der Teilspannungsabgriffspunkt TA bei normalem Spannungswert von VDD auf etwa 3 V.

Der zur Erzeugung der Teilspannung erforderliche Querstrom fließt durch SW1. Da dieser Strom im Normalbetrieb der Referenzspannungsquelle dauernd fließt, wird er mit Hilfe des im leitenden Zustand hochohmigen Transistors SW1 auf dem bereits erwähnten niedrigen Wert von einigen hundert nA gehalten.

Da im Normalbetrieb der Referenzspannungsquelle das Transmissionsgate TG2 leitend geschaltet ist, erscheint der am Teilspannungsabgriffspunkt TA auftretende Spannungswert von etwa 3 V am Ausgang REFOUT der Referenzspannungsquelle.

Anstelle des Transistors D könnte auch ein anderes Bauelement mit festem Spannungsabfall eingesetzt werden, beispielsweise eine Diode.

Es wird nun der Zweck der beschriebenen Referenzspannungsquelle erläutert.

Ein Auslesen der "statischen EPROM-Zelle" der erfindungsgemäßen Speicherschaltung mit einer zu hohen Spannung (z.B. VDD) ist aus folgenden Gründen nachteilig:

a) Überschreitet die Ausgangsspannung VREF der Referenzspannungsquelle REF die Einsetzspannung des programmierten EPROM-Transistors, beginnt in der statischen EPROM-Zelle ein Querstrom zu fließen. Dies deshalb, weil der MOS-Transistor, der mit dem programmierten EPROM-Transistor in Reihe geschaltet ist, leitet. Die Folge ist ein Anstieg des Stromverbrauchs der integrierten Schaltung. Dies ist unerwünscht, insbesondere dann, wenn die Energieversorgung aus einer Batterie stattfindet. Es ist dabei zu erwähnen, daß aufgrund natürlicher Alterung die Einsetzspannung programmierter EPROM-Transistoren ständig sinkt. Dies deshalb, weil von den Ladungen, die auf dem Floatinggate des programmierten EPROM-Transistors gespeichert sind, ständig Ladungen verloren gehen.

b) Falls ein Querstrom durch einen programmierten EPROM-Transistor und den damit in Reihe geschalteten MOS-Transistor fließt, kann der Effekt des sogenannten "Softprogramming" eintreten. D. h., daß der gelöschte EPROM-Transistor im Laufe der Zeit unabsichtlich programmiert wird, weil aufgrund des Querstroms Ladungen auf das Floatinggate gelangen. Dadurch besteht die Gefahr, daß die statische EPROM-Zelle im Laufe der Zeit die gespeicherte Information verliert oder sich die gespeicherte Information verändert.

Beide Effekte bedeuten einen erheblichen Nachteil und können in der Praxis zu einem Systemausfall der von dem Speicherinhalt der Speicherzelle gesteuerten Schaltung führen.

Die Refernzspannungsquelle REF der erfindungsgemäßen Speicherschaltung weist den Vorteil auf, daß die Referenzspannung VREF immer nur um etwa 900 mV über der Einsetzspannung des gelöschten EPROM-Transistors liegt. Denn die Referenzspannung VREF der Referenzspannungsquelle wird, wie bereits erwähnt, durch die Summe der Einsetzspannung des dritten, als Diode geschalteten EPROM-Transistors E3 in Höhe etwa 1,9 V und die Einsetzspannung des als Diode geschalteten Transistors D in Höhe von etwa 0,9 V bestimmt. Da der EPROM-Transistor E3 der Referenzspannungsquelle REF zu derselben monolithisch integrierten Halbleiterschaltung gehört wie die EPROM-Transistoren E1 und E2 der EPROM-Zelle, verhält sich E3 genauso wie E1 und E2. Dadurch wird die gesamte Speicherschaltung einschließlich der Referenzspannungsquelle technologieabhängig, was große Sicherheit bedeutet. Verschiebt sich die Einsetzspannung der EPROM-Transistoren E1 und E2 der EPROM-Zelle aufgrund von Prozeßschwankungen des Verfahrens zur Herstellung der integrierten Schaltung, macht der EPROM-Transistor E3 in der Referenzspannungsquelle diese Verschiebung mit. D.h., ändert sich aufgrund von Prozeßschwankungen die Einsetzspannung von E1 und E2, ändert sich die Einsetzspannung von E3 entsprechend und wird die Referenzspannung VREF der Referenzspannungsquelle REF entsprechend korrigiert.

Nimmt die Versorgungsspannung VDD ab, bleiben die Spannungsabfälle über D und E3 konstant etwa 0,9 V bzw. etwa 1,9 V. D.h., der Spannungsabfall über dem leitenden Schalttransistor SW1 nimmt ab. Reicht die Versorgungspannung VDD nicht mehr aus, um über D und E3 diesen konstanten Spannungabfälle zu ermöglichen, gehen D und E3 in den nicht leitenden Zustand über. Am Teilspannungsabgriffspunkt TA und damit am Ausgang der Referenzspannungsquelle REF stellt sich dann als Potential die abgesunkene Versorgungsspannung VDD ein. Dadurch wird das Auslesen der statischen EPROM-Zelle der erfindungsgemäßen Speicherschaltung bis zum Absinken von VDD bis zu der von der Herstellungstechnologie abhängigen Einsetzspannung ($V_{thEPROM}$ - 1,9 V) ermöglicht.

2. RESET-Betrieb:

Im RESET-Betrieb liegen Logiksignalwerte und Spannungswerte vor wie bei dem oben beschriebenen Normalbetrieb bis auf das Logiksignal RESETN, das jetzt auf dem Logikwert "0" liegt. Dadurch wird der zweite Schalttransistor SW2 leitend geschaltet. SW2 ist ein niederohmig leitender Transistor. Im RESET-Betrieb wird somit der hochohmigen Strecke des leitenden SW1 die niederohmig leitende Strecke von SW2 parallel geschaltet. Dies bewirkt, daß über den Ausgang REFOUT der Referenzspannungsquelle REF ein größerer Strom in die Speicherschaltung geschickt wird als beim Leiten nur des ersten Schalttransistors SW1. Die an REFOUT angeschlossenen Gate-Elektroden stellen eine gewisse Kapazität dar. Dadurch, daß durch Einschalten von SW2 ein höherer Strom von REFOUT geliefert wird, werden diese Kapazitäten schneller aufgeladen. Beim RESET-Betrieb, also beim Einschalten der Schaltungsanordnung, kommt es daher zu einer schnelleren Stabilisierung der gesamten Schaltung als wenn nur der hochohmig leitende Schalttransistor SW1 eingeschaltet wäre.

Aufgrund des niederohmig leitenden Schalttransistors SW2 liegt die Referenzspannung VREF um einige wenige hundert mV höher als im Normalbetrieb, was einen Vorteil auch für die Dynamik des automatischen Auslesens der statischen EPROM-Zelle beim Einschalten der Schaltungsanordnung im RESET-Betrieb bedeutet.

3. Programmierbetrieb:

Für den Programmierbetrieb wird die Referenzspannungsquelle REF derart betrieben, daß sie eine Referenzspannung VREF liefert, die zum Programmieren des betroffenen der beiden EPROM-Transistoren E1 und E2 der Speicherschaltung geeignet ist. In diesem Betrieb liegen folgende Logiksignale an:

OTPTEST = 0

RESETN = 1

PROG = 1.

Die Programmierspannungsquelle weist dabei eine Programmierspannung VPROG = 12,5 V auf. Die Versorgungsspannung bleibt VDD = 5 V.

PROG = 1 bedeutet, das die Transistoren P3 und N3 leiten, die Transistoren P2 und N2 dagegen sperren. D.h., daß Transmissionsgate TG3 leitet, während das Transmissionsgate TG2 sperrt. Auf den Ausgang REFOUT der Referenzspannungsquelle REF gelangt daher die Programmierspannung von etwa 12,5 V. Die statische EPROM-Zelle kann somit über die Eingänge PS1 und PS2 programmiert werden.

Wie in Fig. 3 gezeigt ist, ist der aus den Transistoren P4 und N4 bestehende Inverter IN4 der Referenzspannungsquelle REF nicht an VDD angeschlossen sondern an VPROG. Außerdem wird die n-leitende Wanne der integrierten Schaltung, in der sich die Transistoren P2, P3 und P4 befinden, an das Potential von VPROG angeschlossen. Würde man dies nicht tun, entstünden im Programmierbetrieb Kurzschlüsse in Form leitender Dioden in der n-Wanne. Außerdem muß beim Logikwert "1" das Logiksignal PROG auf dem Potential von VPROG von etwa 12,5 V liegen, weil ansonsten der Inverter IN4 Querstrom ziehen würde und TG2 nicht sperren würde.

4. Testbetrieb:

Je nach dem, was für Speicherelemente man für die Speicherschaltung verwendet, wird die Referenzspannungsquelle REF unterschiedlich betrieben.

a) Speicherschaltung mit EPROM-Transistoren:

In diesem Fall wird die Referenezspannungs-quelle REF wie im Normalbetrieb betrieben. Beide PROM-Transistoren E1 und E2 der Speicherschaltung werden zunächst programmiert, so daß sie beim normalen Lesebetrieb beide sperren. Danach werden die Simulationstransistoren SIT1 und SIT2 je nach den gewünschten Testbedingungen in den leitenden oder den sperrenden Zustand gesteuert.

b) Nur einmal programmierbare Speicherelemente:

Nur einmal programmierbare Speicherelemente, auch als OTP-Elemente (OTP = One Time Programmable) bekannt, haben einen gleichen Halbleiteraufbau wie EPROM-Transistoren. Die OTP-Transistoren werden jedoch in ein Gehäuse ohne Fenster verpackt, wie es EPROM-Transistoren aufweisen, um sie zum Zweck des Löschens mit UV-Licht bestrahlen zu können. Bei den OTP-Transistoren ist nach dem Verpacken nur noch ein einziger Programmiervorgang möglich, da sie nicht mehr durch UV-Licht gelöscht werden können.

Üblicherweise muß jedes Speicherelement zweimal getestet werden. Einmal vor dem Verpacken und einmal nach dem Verpacken. Nach dem Verpacken ist bei OTP-Elementen jedoch ein Programmieren zu Testzwecken nicht mehr erlaubt, weil eine weitere Programmierung nicht möglich ist. Ein Testbetrieb wie im obigen Abschnitt a) beschrieben, ist daher nicht möglich.

Um die statische Speicherzelle dennoch testen zu können, wird nun in der Referenzspannugsquelle REF das Logiksignal OTPTEST auf den Logikwert "1" gesetzt. Alle anderen Logiksignale und Spannungswerte sind wie im Normalbetrieb gewählt. Der Logikwert "1" des Logiksignals OTPTEST führt dazu, daß SW1 sperrt und SW3 leitet. Dadurch wird der Teilspannungsabgriffspunkt TA und somit auch der Ausgang REFOUT der Referenzspannungsquelle REF auf Masse geschaltet. Das bedeutet aber, daß nicht nur die programmierten sondern auch die nicht-programmierten Speichertransistoren in der statischen Speicherzelle nicht leiten und sich somit wie programmierte Transistoren verhalten. Getestet werden kann nun wieder unter Zuhilfenahme der Simulationstransistoren SIT1 und SIT2.

5. Betrieb für eine ROM-Speicherschaltung:

Durch Abänderung der Maskenfolge und Einführung einer speziellen Implantationsmaske bei der Herstellung der Speichertransistoren ist es möglich, die statische Speicherzelle bereits bei der Herstellung definiert zu programmieren. Dabei werden die EPROM-Transistoren E1 und E2 zu normalen N-Kanal-Transistoren umgewandelt, wobei der zu programmierende Transistor an seiner Drainseite unterbrochen wird. Dies geschieht durch Unterbrechung der Diffusion.

Dadurch ist es erlaubt, auch eine hohe Referenzspannung VREF oder VDD als Referenzspannung zuzulassen. Es besteht keine Gefahr des Querstroms, da der programmierte Transistor nie leitend werden kann.

Dabei macht es Sinn, die Referenzspannung VREF auf VDD zu setzen und die Referenzspannungsquelle REF ganz abzuschalten, um auch den kleinen Querstrom zu unterbinden, den die Referenzspannungsquelle im Normalbetrieb aufgrund des Leitens des hochohmig leitenden Schalttransistors SW1 zieht.

Im Fall der Erzeugung einer Referenzspannung für eine EPROM-Speicherschaltung ist der niederohmige Diffusionswiderstand R wirksam. Bei Gestaltung der Speichertransistoren als ROM-Transistoren wird die Diffusion dieses Diffusionswiderstandes R durch die spezielle Implantationsmaske unterbrochen, so daß der leitende Pfad SW1 (und gegebenenfalls SW2), D und E3 gesperrt ist und der Ausgang REFOUT der Referenzspannungsquelle REF über SW1 (und gegebenenfalls zusätzlich über SW2) mit VDD verbunden wird.

In der Regel wird es nicht nötig sein, das Logiksignal OTPTEST vom Logikwert "0" auf den Logikwert "1" umzuschalten, da bei der statischen ROM-Zelle der per Maskensatz festgelegte Ausgangszustand geprüft werden muß.

Anstatt die Diffusion des Diffusionswiderstandes R zu unterbrechen, ist es auch möglich, die Diffusion an der Drainseite des EPROM-Transistors E3 zu unterbrechen, in der gleichen Weise, wie dies bei der Programmierung der statischen ROM-Zelle der Speicherschaltung geschieht.

Die vorausgehenden Betrachtungen zeigen, daß die beschriebene Referenzspannungsquelle REF große Sicherheit und Flexibilität der Speicherschaltung ermöglicht:

- von der Herstellungstechnologie unabhängige Referenzspannungspannung;
- Test von OTP-Elementen in der Verpackung möglich;
- Schutz vor alterungsbedingtem fehlerhaftem Auslesen des Speicherwertes und damit Schutz vor alterungsbedingtem Systemausfall;
- schnelles Einschaltverhalten;
- Programmiermöglichkeit; und

- Übergang zur statischen ROM-Speicherzelle mit der gleichen Schaltung möglich.

Bei einer Ausführungsform der erfindungsgemäßen Speicherschaltung, die mit E$^2$PROM-Transistoren ausgerüstet ist, könnte man über die an die Programmiersignalquellen PS1 und PS2 anschlossenen Leitungen und über das Umschalten der umschaltbaren Referenzspannungsquelle sowohl eine Programmierung als auch ein Löschen als auch ein Auslesen der E$^2$PROM-Transistoren durchführen. Es brauchten lediglich die Spannungswerte geändert zu werden, um für jeden dieser drei Vorgänge die geeigneten Spannungswerte an die entsprechenden Elektroden der E$^2$PROM-Transistoren anzulegen.

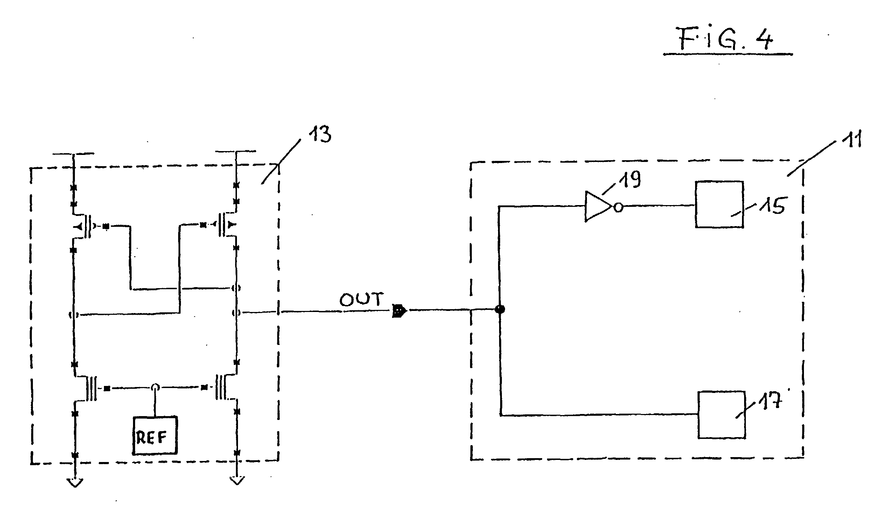

**Fig. 4** zeigt ein schematisiertes Prinzipschaltbild einer Schaltungsanordnung 11, die mit Hilfe des Ausgangssignals einer erfindungsgemäßen Speicherschaltung 13 zwischen zwei Betriebszuständen umschaltbar ist. Dabei ist die Speicherschaltung 13 in sehr vereinfachter Grundform dargestellt. Die verschiedenen Betriebszustände werden bei diesem Beispiel durch einen ersten Schaltungsteil 15 bzw. einen zweiten Schaltungsteil 17 realisiert. Nimmt man an, daß jeder der beiden Schaltungsteile 15 und 17 durch ein Steuersignal "1" aktivierbar und durch ein Steuersignal "0" abschaltbar ist, wäre bei einem Ausgangssignal "1" am Ausgang OUT der Speicherschaltung 13 der Schaltungsteil 17 aktiv und der Schaltungsteil 15 aufgrund eines ihm vorgeschalteten Inverters 19 abgeschaltet.

Die Vorteile der erfindungsgemäßen Speicherschaltung kann man nochmals zusammenfassen wie folgt:

- Störunanfälligkeit im Vergleich zu dynamischen Schaltungskonzepten;
- statische Lösung, d.h. es sind keinerlei Steuersignale notwendig;
- Programmierbarkeit;
- Testbarkeit;
- Aufwandminimierung: Um verschiedene Hardware-Zustände einer integrierten Schaltung zu definieren, sind nicht mehr verschiedene Masken erforderlich oder das Durchschmelzen von Metallbrücken;
- durch Tauschen einiger Masken kann aus der EPROM-programmierbaren Zellen eine festprogrammierte ROM-Zelle gemacht werden. Auf diese Weise kann man Pilotserien, die mit EPROM-programmierbaren Zellen aufgebaut sind, in Großserien mit festprogrammierten ROM-Zellen bringen.

**Patentansprüche**

**1.** Elektronische Speicherschaltung zum Speichern von Information, mit einer zwischen die beiden Pole (VDD, GND) einer Versorgungsspannungsquelle geschalteten Parallelschaltung mit einer ersten Reihenschaltung mit einem ersten EPROM-Transistor (E1), einem ersten MOS-Transistor (M1) und einem dazwischen befindlichen ersten Schaltungsknoten (SK1), und einer zweiten Reihenschaltung mit einem zweiten EPROM-Transistor (E2), einem zweiten MOS-Transistor (M2) und einem zweiten Schaltungsknoten (SK2), wobei die gespeicherte Information von dem durch den Programmierungszustand der EPROM-Transistoren (E1, E2) gegebenen Schaltzustand abhängt, das Gate eines jeden der beiden MOS-Transistoren (M1, M2) mit dem Schaltungsknoten (SK1, SK2) der je anderen Reihenschaltung verbunden ist und der Schaltungsknoten (SK2) einer (E2, M2) der beiden Reihenschaltungen (E1, M1, E2, M2) das Ausgangssignal der Speicherschaltung liefert, **dadurch gekennzeichnet,**

- **daß** die beiden EPROM-Transistoren (E1, E2) mit einer Programmiereinrichtung verbunden sind, mittels welcher je nach zu speichernder Information immer nur der erste (E1) oder der zweite (E2) EPROM-Transistor in einen programmierten Zustand und der jeweils andere EPROM-Transistor (E1, E2) in einen unprogrammierten Zustand bringbar ist;

- **daß** die Programmiereinrichtung aufweist:

  einen ersten (PT1) und einen zweiten (PT2) Programmier-Transistor, über welche die zum zugehörigen MOS-Transistor (M1, M2) weisende Seite des EPROM-Transistors (E1, E2) der ersten bzw. der zweiten Reihenschaltung mit einer Programmiersignaleinrichtung (PS1, PS2) verbunden ist, die während eines Programmiervorgangs nur an einen auswählbaren der beiden EPROM-Transistoren (E1, E2) ein Programmiersignal und an den anderen kein Programmiersignal anlegt, und

  eine Programmiersteuersignaleinrichtung (PROG), die während eines Programmiervorgangs die beiden Programmier-Transistoren (PT1, PT2) leitend schaltet;

- **daß** in jeder der beiden Reihenschaltungen zwischen den Schaltungsknoten (SK1, SK2) und den Verbindungspunkt zwischen EPROM-Transistor (E1, E2) und Programmier-Transistor (PT1, PT2) ein Sperr-Transistor (ST1, ST2) geschaltet ist, der mittels der Programmiersteuersignaleinrichtung (PROG) während eines Programmiervorgangs in einen Sperrzustand und ansonsten in einen leitenden Zustand schaltbar ist;

- **daß** jedem der beiden EPROM-Transistoren (E1, E2) mindestens ein Simulations-Transistor (SIT1, SIT2) parallel oder in Reihe geschaltet ist, von denen jeder zu Testsimulationszwecken mittels eines je zugehörigen Testsignals wahlweise in einen leitenden oder einen sperrenden Zustand schaltbar ist;

- **daß** die Steuergates der beiden EPROM-Transistoren (E1, E2) gemeinsam mit einer Referenzspannungsquelle (REF) verbunden sind, die aufweist:

  einen zwischen die beiden Pole (VDD, GND) der Versorgungsspannungsquelle geschalteten Spannungsteiler (SW1, D, E3) mit einem zwischen einen (VDD) der beiden Pole und einem Teilspannungsabgriffspunkt (TA) geschalteten ersten Schalttransistor (SW1) und einer zwischen dem Teilspannungsabgriffspunkt (TA) und den anderen (GND) der beiden Pole geschalteten Reihenschaltung mit einem ersten Schaltungselement (D) mit konstantem Spannungsabfall und einem zweiten Schaltungselement mit konstantem Spannungsabfall in Form eines als Diode geschalteten dritten EPROM-Transistors (E3), wobei der Spannungsteiler derart dimensioniert ist, daß die an seinem Teilspannungsabgriffspunkt (TA) liegende Spannung ausreicht, um den unprogrammierten EPROM-Transistor (E1, E2) in den leitenden Zustand zu schalten, nicht jedoch den programmierten EPROM-Transistor (E1, E2),

  einen ersten steuerbaren Schalter (TG2), der zwischen den Teilspannungsabgriffspunkt (TA) und den Ausgang (REFOUT) der Referenzspannungsquelle (REF) geschaltet ist und im leitend geschalteten Zustand den an dem Teilspannungsabgriffspunkt (TA) vorhandenen Teilspannungswert zum Ausgang (REFOUT) durchschaltet,

  eine Programmierreferenzspannungsquelle (VPROG) mit einer zum Programmieren eines EPROM-Transistors (E1, E2) ausreichend hohen Programmierreferenzspannung,

  und einen zweiten steuerbaren Schalter (TG3), der zwischen die Programmierreferenzspannungsquelle (VPROG) und den Ausgang (REFOUT) der Referenzspannungsquelle (REF) geschaltet ist und im leitend geschalteten Zustand die Programmierreferenzspannung zum Ausgang (REFOUT) durchschaltet,

wobei die leitenden steuerbaren Schalter (TG2) und (TG3) von der Programmiersteuersignaleinrichtung (PROG) derart gesteuert werden, daß während eines Programmiervorgangs nur der zweite steuerbare Schalter (TG3) und ansonsten nur der erste steuerbare Schalter (TG2) leitend geschaltet ist,
und wobei die drei EPROM-Transistoren (E1, E2, E3) Teil ein und derselben monolithisch integrierten Halbleiterschaltung und gleiches Betriebsverhalten aufweisen.

2. Speicherschaltung nach Anspruch 1, **dadurch gekennzeichnet, daß** der erste Schalttransistor (SW1) als hochohmig leitender Transistor ausgebildet ist.

3. Speicherschaltung nach Anspruch 2, **dadurch gekennzeichnet, daß** der erste Schalttransistor (SW1) im leitenden Zustand einen Widerstand im Bereich von etwa 10 MΩ bis etwa 20 MΩ aufweist.

4. Speicherschaltung nach einem der Ansprüche 1 bis 3, **dadurch gekennzeichnet, daß** dem ersten Schalttransistor (SW1) ein niederohmig leitender zweiter Schalttransistor (SW2) parallel geschaltet ist, der beim Einschalten der Speicherschaltung für eine vorbestimmte Einschaltzeitdauer leitend gesteuert wird.

5. Speicherschaltung nach einem der Ansprüche 1 bis 4, dadurch gekennzeichent, daß zwischen den Teilspannungsabgriffspunkt (TA) und den anderen Pol (GND) der Versorgungsspannungsquelle ein dritter Schalttransistor (SW3) geschaltet ist, der gegenläufig zum ersten Schalttransistor (SW1) in den leitenden oder sperrenden Zustand steuerbar ist.

6. Speicherschaltung nach einem der Ansprüche 1 bis 5, **dadurch gekennzeichnet, daß** in die Reihenschaltung zwischen dem Teilspannungsabgriffspunkt (TA) und dem anderen Pol (GND) der Versorgungsspannungsquelle eine Brücke (R) geschaltet ist, die wahlweise in einen leitenden oder einen nicht leitenden Zustand bringbar ist.

7. Speicherschaltung nach einem der Ansprüche 1 bis 6, **dadurch gekennzeichnet, daß** die gespeicherte Information von dem Schaltungsknoten (SK2) einer der beiden Reihenschaltungen abnehmbar ist und daß mit diesem Schaltungsknoten (SK2) eine Halteschaltung (INV1, INV2, INV3, TG1) verbunden ist, in welcher die an diesem Schaltungsknoten (SK2) jeweils auftretende Information mindestens für die Zeitdauer speicherbar ist, während welcher die Sperr-Transistoren (ST1, ST2) in den Sperrzustand gesteuert sind.

8. Speicherschaltung nach einem der Ansprüche 1 bis 7, **dadurch gekennzeichnet, daß** anstelle des ersten und des zweiten EPROM-Transistors (E1, E2) je ein nur einmal programmierbares PROM-Element vorgesehen ist.

9. Speicherschaltung nach einem der Ansprüche 1 bis 7, **dadurch gekennzeichnet, daß** anstelle des ersten und des zweiten EPROM-Transistors (E1, E2) je ein fest programmiertes ROM-Element vorgesehen ist.

10. Schaltungsanordnung mit mehreren wählbaren Funktionen, deren Auswahl mittels mindestens eines steuerbaren Schalters erfolgt, **gekennzeichnet durch** eine Speicherschaltung nach einem der Ansprüche 1 bis 9, von der Schalter seine die Auswahl bestimmende Schaltsteuerinformation erhält.

11. Schaltungsanordnung nach Anspruch 10, **dadurch gekennzeichnet, daß** sie monolithisch integriert ist.

**Claims**

1. Electronic memory circuit for storing information, with a parallel circuit, connected between the two poles (VDD, GND) of a voltage supply source, with a first series circuit with a first EPROM transistor (E1), a first MOS transistor (M1) and a first circuit node (SK1) situated between them, and a second series circuit with a second EPROM transistor (E2), a second MOS transistor (M2) and a second circuit node (SK2), the stored information being dependent on the switching state given by the programming state of the EPROM transistors (E1, E2), the gate of each of the two MOS transistors (M1, M2) being connected to the circuit node (SK1, SK2) of the respective other series circuit and the circuit node (SK2) of one (E2, M2) of the two series circuits (E1, M1, E2, M2) providing the output signal of the memory circuit, **characterised in that**

- the two EPROM transistors (E1, E2) are connected to a programming device by means of which, depending on the information to be stored, only the first (E1) or the second (E2) EPROM transistor can ever be brought into a programmed state and the respective other EPROM transistor (E1, E2) can ever be brought into an unprogrammed state;
- the programming device has:

a first (PT1) and a second (PT2) programming transistor, via which the side of the EPROM transistor (E1, E2) of the first or the second series circuit respectively facing the associated MOS transistor (M1, M2) is connected to a programming signal device (PS1, PS2), which, during the programming process, applies a programming signal only to a selectable one of the two EPROM transistors (E1, E2) and no programming signal to the other, and

a programming control signal device (PROG), which switches the two programming transistors (PT1, PT2) to a conducting state during a programming process;

-   in each of the two series circuits, a blocking transistor (ST1, ST2) is connected between the circuit nodes (SK1, SK2) and the connection point between the EPROM transistor (E1, E2) and the programming transistor (PT1, PT2), which, during a programming process, can be switched to a blocking state by means of the programming control signal device (PROG) and at other times to a conducting state;

-   at least one simulation transistor (SIT1, SIT2) is connected in parallel or in series with each of the two EPROM transistors (E1, E2), each of which can optionally be switched to a conducting or a blocking state for test simulation purposes by means of a test signal associated with each;

-   the control gates of the two EPROM transistors (E1, E2) are connected to a common reference voltage source (REF), which has:

    a voltage divider (SW1, D, E3) connected between the two poles (VDD, GND) of the supply voltage source with a first switching transistor (SW1) connected between one (VDD) of the two poles and a partial-voltage take-off point (TA) and a series circuit connected between the partial-voltage take-off point (TA) and the other (GND) of the two poles with a first circuit element (D) with a constant voltage drop and a second circuit element with a constant voltage drop in the form of a third EPROM transistor (E3) connected as a diode, the voltage divider being sized such that the voltage at its partial-voltage take-off point (TA) is sufficient to switch the unprogrammed EPROM transistor (E1, E2) to the conducting state but not the programmed EPROM transistor (E1, E2),

    a first controllable switch (TG2), which is connected between the partial-voltage take-off point (TA) and the output (REFOUT) of the reference voltage source (REF) and which switches the partial voltage present at the partial-voltage take-off point (TA) through to the output (REFOUT) when switched to the conducting state,

    a programming reference voltage source (VPROG) with a programming reference voltage of sufficient magnitude to program an EPROM transistor (E1, E2)

    and a second controllable switch (TG3), which is connected between the programming reference voltage source (VPROG) and the output (REFOUT) of the reference voltage source (REF) and which switches the programming reference voltage through to the output (REFOUT) when switched to the conducting state,

    the conducting controllable switches (TG2) and (TG3) being driven by the programming control signal device (PROG) such that, during a programming process, only the second controllable switch (TG3) and at other times only the first controllable switch (TG2) is switched to a conducting state,

    and the three EPROM transistors (E1, E2, E3) being part of one and the same monolithically integrated semiconductor circuit and having the same operating behaviour.

2.  Memory circuit according to Claim 1, **characterised in that** the first switching transistor (SW1) is designed as a high-conduction-impedance transistor.

3.  Memory circuit according to Claim 2, **characterised in that** the first switching transistor (SW1) has a resistance in the conducting state in the range of about 10 MΩ to about 20 MΩ.

4.  Memory circuit according to one of Claims 1 to 3, **characterised in that** a low-conduction-impedance second switching transistor (SW2) is connected in parallel with the first switching transistor (SW1), which is driven so as to conduct for a predetermined switch-on period when the memory circuit is switched on.

5.  Memory circuit according to one of Claims 1 to 4, **characterised in that** a third switching transistor (SW3) is connected between the partial-voltage take-off point (TA) and the other pole (GND) of the supply voltage source, which can be driven to the conducting or blocking state opposite to that of the first switching transistor (SW1).

6.  Memory circuit according to one of Claims 1 to 5, **characterised in that** a bridge (R) is connected in the series circuit between the partial-voltage take-off point (TA) and the other pole (GND) of the supply voltage source, which can optionally be brought into a conducting or a non-conducting state.

7. Memory circuit according to one of Claims 1 to 6, **characterised in that** the stored information can be taken off from the circuit node (SK2) of one of the two series circuits and that a holding circuit (INV1, INV2, INV3, TG1) is connected to this circuit node (SK2) and in which the respective information appearing at this circuit node (SK2) can be stored at least for the period of time during which the blocking transistors (ST1, ST2) are driven to the blocking state.

8. Memory circuit according to one of Claims 1 to 7, **characterised in that** a PROM element which can only be programmed once is provided in place of each of the first and the second EPROM transistor (E1, E2).

9. Memory circuit according to one of Claims 1 to 7, **characterised in that** a permanently programmed ROM element is provided in place of each of the first and of the second EPROM transistor (E1, E2).

10. Circuit arrangement with several selectable functions, the selection of which is made using at least one controllable switch, **characterised by** a memory circuit according to one of Claims 1 to 9, from which the switch receives its switching control information which determines the selection.

11. Circuit arrangement according to Claim 10, **characterised in that** it is integrated monolithically.

**Revendications**

1. Dispositif électronique de mémoire pour mémoriser des informations, comprenant un circuit parallèle couplé entre deux pôles (VDD, GND) d'une source de tension d'alimentation, comportant un premier circuit série comprenant un premier transistor EPROM (E1), un premier transistor MOS (M1) et un premier noeud (SK1) disposé entre ceux-ci, et comportant en outre un deuxième circuit série comprenant un deuxième transistor EPROM (E2), un deuxième transistor MOS (M2) et un deuxième noeud (SK2), dans lequel l'information stockée dépend de l'état de conduction, déterminé par l'état de programmation, des transistors EPROM (E1, E2), la grille de chacun des deux transistors MOS (M1, M2) étant reliée respectivement au noeud (SK1, SK2) de l'autre circuit série et le noeud (SK2) de l'un (E2, M2) des deux circuits série (E1, M1, E2, M2) fournit le signal de sortie du dispositif de mémoire, **caractérisé :**

- **en ce que** les deux transistors EPROM (E1, E2) sont reliés à un dispositif de programmation, au moyen duquel, selon l'information à stocker, le premier (E1) ou le deuxième (E2) transistor EPROM seulement est porté à un état programmé, l'autre transistor EPROM (E1, E2) étant porté à un état non programmé ;

- **en ce que** le dispositif de programmation comporte :

  un premier (PT1) et un deuxième (PT2) transistors de programmation, par l'intermédiaire desquels le côté du transistor EPROM (E1, E2) associé au transistor MOS correspondant (M1, M2) du premier, respectivement deuxième, circuit série est relié à un dispositif de signal de programmation (PS1, PS2) qui, pendant un processus de programmation, fournit un signal de programmation à l'un choisi des deux transistors EPROM (E1, E2) et aucun signal de programmation à l'autre, et
  un dispositif de signal de commande de programmation (PROG), qui, pendant un processus de programmation, rend conducteurs les deux transistors de programmation (PT1, PT2) ;

- **en ce que**, dans chacun des deux circuits série, un transistor de blocage (ST1, ST2) est disposé entre ledit noeud (SK1, SK2) et le point de liaison entre le transistor EPROM (E1, E2) et le transistor de programmation (PT1, PT2), le transistor de blocage pouvant être porté à un état bloqué au moyen du dispositif de signal de commande de programmation (PROG) pendant un processus de programmation et à un état conducteur dans les autres cas ;

- **en ce qu'**est connecté en parallèle ou en série avec chacun des deux transistors EPROM (E1, E2) au moins un transistor de simulation (SIT1, SIT2), par lesquels chacun peut être commuté au choix à l'état passant ou bloqué au moyen d'un signal de test associé dans un but de test; et

- **en ce que** les grilles de commande des deux transistors EPROM (E1, E2) sont reliées ensemble à une source de tension de référence (REF) comportant :

  un diviseur de tension (SW1, D, E3) disposé entre les deux pôles (VDD, GND) de la source de tension d'alimentation comprenant un premier transistor de commutation (SW1) disposé entre un des deux pôles (VDD) et un point de prise de tension intermédiaire (TA) et un circuit série disposé entre le point de prise de tension intermédiaire (TA) et l'autre des deux pôles (GND), le circuit série comportant un premier élément (D) à chute de tension constante et un deuxième élément à chute de tension constante sous forme d'un troisième transistor EPROM (E3) connecté en diode, le diviseur de tension étant dimensionné de sorte que la tension se trouvant au point de prise de tension intermédiaire (TA) est suffisante pour porter le transistor EPROM (E1, E2) non programmé à l'état conducteur, sans pour autant y porter le transistor EPROM programmé (E1, E2) ;

un premier commutateur commandable (TG2), disposé entre le point de prise de tension intermédiaire (TA) et la sortie (REFOUT) de la source de tension de référence (REF), et transmettant à la sortie (REFOUT), à l'état conducteur, la valeur de la tension présente au point de prise de tension intermédiaire (TA) ;

une source de tension de référence de programmation (VPROG) présentant une tension de référence de programmation suffisamment élevée pour programmer un transistor EPROM (E1, E2) ; et

un deuxième commutateur commandable (TG3), disposé entre la source de tension de référence de programmation (VPROG) et la sortie (REFOUT) de la source de tension de référence (REF), et transmettant, à l'état passant, la tension de référence de programmation à la sortie (REFOUT),

dans lequel les commutateurs commandables (TG2) et (TG3) sont commandés par le dispositif de signal de commande de programmation (PROG) de sorte que, pendant un processus de programmation, le deuxième commutateur commandable (TG3) seulement est rendu passant, le premier commutateur commandable (TG2) étant rendu passant dans les autres cas,

et dans lequel les trois transistors EPROM (E1, E2, E3) font partie d'un même circuit intégré monolithique à semiconducteur et présentent un même comportement de fonctionnement.

2. Dispositif de mémoire selon la revendication 1, **caractérisé en ce que** le premier transistor de commutation (SW1) est réalisé comme transistor à haute impédance en conduction.

3. Dispositif de mémoire selon la revendication 2, **caractérisé en ce que** le premier transistor de commutation (SW1) présente, à l'état passant, une résistance appartenant à un domaine allant d'environ 10 MΩ jusqu'à environ 20 MΩ.

4. Dispositif de mémoire selon l'une des revendications 1 à 3, **caractérisé en ce qu'**un deuxième transistor de commutation, (SW2) à faible impédance à l'état passant, est disposé en parallèle avec le premier transistor de commutation (SW1), le deuxième transistor de commutation étant commandé à l'état passant pour une durée déterminée, lors de la mise en service du dispositif de mémoire.

5. Dispositif de mémoire selon l'une des revendications 1 à 4, **caractérisé en ce qu'**un troisième transistor de commutation (SW3) est disposé entre le point de prise de tension intermédiaire (TA) et l'autre pôle (GND) de la source de tension d'alimentation, le troisième transistor de commutation étant commandable à l'état passant ou bloqué de façon opposée au premier transistor de commutation (SW1).

6. Dispositif de mémoire selon l'une des revendications 1 à 5, **caractérisé en ce qu'**un pont (R) est disposé dans le circuit série entre le point de prise de tension intermédiaire (TA) et l'autre pôle (GND) de la source de tension d'alimentation, le pont pouvant être porté au choix à un état passant ou non passant.

7. Dispositif de mémoire selon l'une des revendications 1 à 6, **caractérisé en ce que** l'information stockée peut être prélevée audit noeud (SK2) d'un des deux circuits série, et **en ce qu'**un circuit de maintien (INV1, INV2, INV3, TG1) est relié à ce noeud (SK2), l'information se présentant à ce noeud (SK2) étant stockable au moins pour la durée pendant laquelle les transistors de blocage (ST1, ST2) sont commandés à l'état bloqué.

8. Dispositif de mémoire selon l'une des revendications 1 à 7, **caractérisé en ce qu'**un élément PROM, programmable une fois seulement, est prévu respectivement à la place du premier et du deuxième transistors EPROM (E1, E2).

9. Dispositif de mémoire selon l'une des revendications 1 à 7, **caractérisé en ce qu'**un élément de type ROM, programmé de manière définitive, est prévu respectivement à la place du premier et du deuxième transistors EPROM (E1, E2).

10. Arrangement présentant plusieurs fonctions pouvant être choisies, le choix ayant lieu au moyen d'au moins un commutateur programmable, **caractérisé par** un dispositif de mémoire selon l'une des revendications 1 à 9 à partir duquel le commutateur reçoit ses informations de commande de commutation.

11. Arrangement selon la revendication 10, **caractérisé en ce qu'**il est intégré de manière monolithique.

FIG. 1

VDD — M1 ◄   M2 ► VDD

SK1   SK2 → OUT

PROGN

ST1   ST2   PT2   PS 2

PS 1   PT1

E1   E2   PROG

SIT 1   SIT 2

TEST 1   GND   REF   GND   GND   TEST 2

GND

EP 0 658 905 B1

FiG.2

INV3

INV2

TG 1

INV1

OUT

STORE

VDD

VDD

M2

M1

ST2

ST1

PROGN

PS2

PS1

E2

E1

REF

GND

GND

GND

GND

SiT2

SiT1

TEST2

TEST1

PROG

FIG. 3

FIG. 4